# EUROPEAN PATENT SPECIFICATION

(11) **EP 3 724 671 B1**
(45) Date of publication and mention of the grant of the patent: **29.03.2023**
(21) Application number: 18703779.1
(22) Date of filing: 07.02.2018
(51) Int. Cl.: G01R 33/30, G01R 33/60, G01N 24/10, G01N 23/083, G01R 33/345

(54) **PROBE SETUP FOR COMBINED EPR AND XAS MEASUREMENTS**
SONDENAUFBAU FÜR KOMBINIERTE EPR- UND XAS-MESSUNGEN
CONFIGURATION DE SONDE POUR MESURES RPE ET XAS COMBINÉES

(43) Date of publication of application: 21.10.2020
(73) Proprietor: Bruker BioSpin GmbH, 76275 Ettlingen (DE)
(72) Inventor: RABEAH, Jabor, 18059 Rostock (DE); BRÜCKNER, Angelika, 18209 Bad Doberan (DE); ADOMEIT, Sven, 13409 Berlin (DE)
(74) Representative: Kleine, Hubertus
(86) International application number: PCT/EP2018/053047
(87) International publication number: WO 2019/154488

(56) References cited:
- JP-A- 2001 108 732
- YOKOYA A ET AL: "EPR spectrometer installed in a soft X-ray beamline at SPring-8 for biophysical studies", NUCLEAR INSTRUMENTS & METHODS IN PHYSICS RESEARCH. SECTION A, ELSEVIER BV * NORTH-HOLLAND, NL, vol. 467-468, 21 July 2001 (2001-07-21), pages 1333-1337, XP004298956, ISSN: 0168-9002, DOI: 10.1016/S0168-9002(01)00661-1 cited in the application
- ANGELIKA BRÜCKNER: "In-situ-EPR-Spektroskopie in der heterogenen Katalyse: Stiefkind oder Lichtblick?", CHEMIE INGENIEUR TECHNIK., vol. 86, no. 11, 8 September 2014 (2014-09-08), pages 1871-1882, XP055522876, WEINHEIM; DE ISSN: 0009-286X, DOI: 10.1002/cite.201400073
- Carlo Lamberti ET AL: "Part III Applications: From Catalysis via Semiconductors to Industrial Applications" In: "X-ray Absorption and X-Ray Emission Spectroscopy: Theory and Applications", 22 January 2016 (2016-01-22), Wiley, XP055522900, pages 353-383, page 358, paragraph 1; figure 13.4 page 365, last paragraph page 369, last paragraph
- ANGELIKA BRÜCKNER ET AL: "In situ-electron spin resonance: a useful tool for the investigation of vanadium phosphate catalysts (VPO) under working conditions", CATALYSIS TODAY, vol. 32, no. 1-4, 16 December 1996 (1996-12-16), pages 215-222, XP055522935, AMSTERDAM, NL ISSN: 0920-5861, DOI: 10.1016/S0920-5861(96)00077-6
- PHILIPP CONSENTIUS ET AL: "Combining EPR spectroscopy and X-ray crystallography to elucidate the structure and dynamics of conformationally constrained spin labels in T4 lysozyme single crystals", PHYSICAL CHEMISTRY CHEMICAL PHYSICS., vol. 19, no. 31, 25 July 2017 (2017-07-25) , pages 20723-20734, XP055523063, GB ISSN: 1463-9076, DOI: 10.1039/C7CP03144K

## Description

The invention relates to a probe setup for combined EPR (electron parametric resonance) and XAS (X-ray absorption spectroscopy) measurements. The invention further relates to an EPR spectrometer with such a probe setup for performing electron parametric resonance measurements while providing the option of X-ray absorption measurements.

Electron parametric resonance spectroscopy is a versatile and powerful method for studying materials that comprise unpaired electrons, e.g. transition metal ions (TMI) in oxides, carbides, sulfides, nitrides and other solid matrices, TMI-complexes as well as organic and inorganic radicals. These materials have wide applications especially in catalysis. EPR measurements can provide information about the valence state of paramagnetic species, their local geometry as well as changes of these properties and intermediates forming during catalytic reactions. EPR measurements are therefore an important tool for an understanding and development of catalytically active materials. Even though, a derivation of structure-reactivity relationships and mechanisms requires information that cannot be provided by a single type of measurement alone. A deeper insight into structure-reactivity relationships and mechanisms is provided by a combination of different analytical methods, which is most reliable when such measurements are performed in situ/operando at the same time and on the same probe object.

In one approach, the simultaneous coupling of EPR and optical spectroscopy measurements by Raman and UV-vis (ultraviolet-visible) spectroscopy is described in an article *"*Killing three birds with one stone - simultaneous operando EPR/UV-vis/Raman spectroscopy for monitoring catalytic reactions" by A. Brückner, Chem. Commun. 13 (2005), pages 1761-1763. The setup shown in this article allows applying three different spectroscopic techniques simultaneously to a probe. Examples of a V/TiO₂ catalyst as a probe during an oxidative dehydrogenation of propane are presented. The article demonstrates that more authentic information of a catalytic system can be obtained by simultaneous application of different spectroscopic techniques.

In particular for analyzing valence state and structure changes of active metal species that are EPR-silent under catalytic reaction conditions (e. g. due to short relaxation times, diamagnetic or antiferromagnetic behavior), X-ray absorption spectroscopy would provide additional and valuable information since this method can generally detect metal species in all valence states and environments.

Suitable X-rays for X-ray absorption spectroscopy (XAS) are usually provided by a synchrotron beamline. Accordingly, an X-ray source and an X-ray energy analyzer cannot be integrated into an EPR spectrometer - instead the EPR spectrometer has to be integrated into the beamline providing X-rays. The successful approaches to integrate IR or UV-vis spectroscopy into an EPR spectrometer, like fiber-optical measurements heads, cannot be resumed for X-ray spectroscopy.

An EPR spectrometer installed in an X-ray beamline of a synchrotron is known from the article *"*EPR spectrometer installed in a soft X-ray beamline at SPring-8 for biophysical studies" by Yokoya and Akamatsu, Nuclear Instruments and Methods in Physics Research A 467-468 (2001) pages 1333-1337. In the article, an X-ray beam provided by a synchrotron facility is guided through a vacuum setup to an X-ray analyzer, for example a fluorescence screen combined with a photo current monitor. A microwave resonator with a cavity in which a sample (probe) is mounted is installed within a vacuum chamber which is part of the vacuum setup through which the X-ray beam passes. The vacuum chamber with the integrated microwave resonator is positioned in the gap between the magnetic pole shoes of the EPR spectrometer.

The described setup is useful for measurements that can be or that have to be performed under vacuum conditions. In situ measurements during reactions that take place either in fluids or in gases at pressures above vacuum level are not accessible with this setup. Furthermore, the introduction of a vacuum chamber including a resonator into the gap of the EPR magnet requires the use of a large EPR magnet with a gap width of at least 10 centimeters (cm). Such a system however is rather stationary and difficult to use in a setup that is only temporarily installed at a synchrotron facility.

It is therefore an object of the present invention to provide a probe setup and a spectrometer equipped with such probe setup that can be used to combine EPR and X-ray absorption spectroscopy measurements with fluid or gaseous samples and/or with solid samples in fluid and/or gaseous environments. It is a further object of the present invention to provide a probe setup that can be used with a smaller sized EPR equipment that can be transported easier.

This object is solved by a probe setup and a spectrometer comprising the features of claims 1 and 20, respectively. Advantageous embodiments are subject matter of the respective dependent claims.

A probe setup according to the invention comprises a microwave resonator and a probe head arranged in a cavity of the resonator. The resonator has an entrance opening and an exit opening for an X-ray beam. The probe head comprises a probe tube which runs through the cavity and crosses the X-ray beam. The probe tube allows transporting liquid or gaseous media through the cavity for simultaneously performing EPR- and XAS-measurements on these media itself or during reactions of the media with a solid probe disposed in the probe tube. To provide liquid media to the probe tube, it can for example be connected to a reactor receptacle. To provide gaseous media to the probe tube, it can be connected to a gas supply.

An EPR spectrometer comprises at least one coil for providing a magnetic field within a gap and a microwave resonator positioned in the gap. According to the invention, the resonator is part of the inventive probe setup described before. Compared to the probe setup described in prior art, no vacuum chamber is needed that encloses the resonator and enlarges the space required between the pole shoes of the spectrometer. Accordingly, due to the inventive probe setup, the EPR spectrometer can be designed as a small bench-top spectrometer with a weight below e.g. 200 kilograms (kg) and in particular below 150 kg. The width of the gap is preferably as small as necessary but as large as possible to ensure an optimum homogeneous magnetic field between the pole shoes. In one embodiment, the width of the gap is smaller than 7 cm and in particular smaller than 5 cm. A suitable X-ray source for the combined EPR and X-ray measurements is usually stationary, in particular provided by a synchrotron facility. The option to use an EPR-spectrometer that is small in size and weight reduces the effort for transporting and for aligning the spectrometer with respect to the beamline of the synchrotron facility.

In particular if a high energy X-ray beam is used, the probe tube can be made from quartz glass. Quartz glass is chemically inert and - given an appropriate wall thickness - the probe tube is self-supporting. In a preferred embodiment, the section of the probe tube in which the X-rays cross has a reduced wall thickness in order to decrease X-ray absorption by the probe tube. By reducing the wall thickness only in the section of the probe tube, where it is exposed to the X-rays, an unwanted X-ray absorption due to the material of the probe tube can be minimized, while the stability of the probe tube is still sufficient for a self-supporting setup.

In an advantageous embodiment of the probe setup, the probe tube is made from Polyimide, preferably with a wall thickness less than 0.5 millimeters (mm) and in particular less than 0.2 mm. Polyimide, also known as Kapton, shows a high mechanical strength that allows to provide a probe tube with very thin walls and accordingly with a very low X-ray absorption.

The probe tube can be inserted into a further tube, wherein a section of the further tube that is positioned in the cavity has a reduced wall thickness to decrease X-ray absorption by the further tube. The further tube can in one embodiment be a support tube that closely encompasses the probe tube. The support tube can for example be made from quartz glass, e.g. with wall thickness in the range of 1 to 2 mm. The combination of a probe tube with very thin walls and a support tube with a reduced wall thickness in the XAS-measurement section leads to a probe head that is firm enough for an easy handling and shows very low X-ray absorption even at low X-ray energies.

Further preferred, a gas adapter is connected to the support tube for feeding a temper gas to the support tube and for tempering at least a section of the probe tube. This way, measurements at defined and in particular elevated temperatures can be performed. Temperatures up to and above 500 K can be reached.

In a further advantageous embodiment of the probe setup, the further tube is an insulation tube that encompasses the probe tube and/or the support tube. In particular if measurements are performed at elevated temperatures, the insulation tube prevents an undesired warming-up of the resonator, which could influence the resonance behavior of the cavity and therefore disturb the EPR-measurements.

The insulation tube can e.g. be made from a plastic material, in particular from PTFE, or can comprises a double-walled evacuated quartz dewar. A further gas adapter can be connected to the insulation tube for feeding a cooling gas to the insulation tube. The cooling gas allows for example for an active cooling of the outside of a support tube, which is used to temper the probe tube.

In a further advantageous embodiment of the probe setup, the wall thickness of the further tube is reduced to zero by placing at least one hole in the material of the further tube. At least one hole can thus be formed in the wall of the support tube and/or in the wall of the insulation tube. In order to prevent temper gas or cooling gas to enter the cavity, the at least one hole can be covered by a thin foil, e.g. a Kapton foil.

In a further advantageous embodiment of the probe setup, the probe tube has an enlarged diameter within at least one section disposed in the cavity. The X-rays preferably cross in this section with the enlarged diameter to gain an enhanced X-ray absorption of the probe, which can be desired to achieve a better signal-to-noise ratio for the X-ray measurements. However, the total amount of probe medium within the cavity is smaller than it would be if the entire probe tube had the enlarged diameter. This can be advantageous if the load of the probe medium within the cavity negatively effects the EPR signal, e.g. if the medium is highly polar.

The invention is now described in more details in connection with embodiments shown in the accompanying drawings. The drawings show:
- Fig. 1: a schematic front view of a resonator positioned in a magnetic gap of an EPR spectrometer and a probe setup according to the invention;
- Fig. 2: a side view of the resonator and an inserted probe head;
- Fig. 3: a detailed view of the probe head used in the setup of Fig. 2;
- Fig. 4: a side view of a second embodiment of a probe head according to the invention;
- Fig. 5: the probe head of Fig. 4 in a disassembled state and with an enlargement of the probe section of the probe head;
- Fig. 6a, b: results of an EPR measurement; and
- Fig. 7: results of XAS studies performed simultaneously to the EPR measurements of Fig. 6.

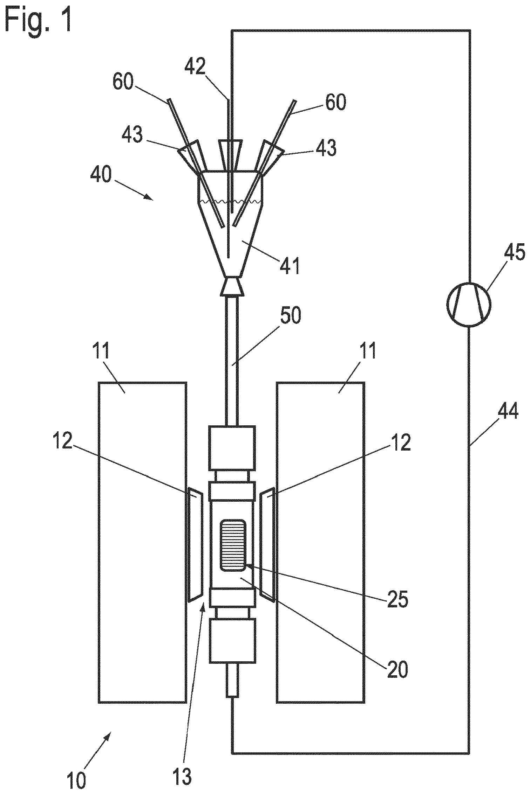

Fig. 1 shows a schematic drawing of an embodiment of a probe unit 40 with a probe head 50, wherein the probe head 50 extends into a resonator 20 of an EPR spectrometer 10.

It is noted that the drawing is a schematic drawing in the sense that components are depicted in a simplified manner or are even reduced to a functional symbol as used in block diagrams. Furthermore, the drawing of Fig. 1 is not true to scale.

It is further noted that identical reference numbers refer to the same or to equal elements in all drawings. As a matter of lucidity, not all elements will be supplied with reference numbers in all figures.

The EPR spectrometer 10, also denoted as spectrometer 10 in the following, is represented in Fig.1 by electromagnetic coils 11 positioned on pole shoes 12. The pole shoes 12 form a gap 13 in which the resonator 20 is positioned.

A small size of the probe head 50 and the resonator 20, as well as the fact that the resonator 20 is positioned directly in the gap 13 between the pole shoes 12 without being surrounded by an additional vacuum chamber, gives the option of using a bench-top spectrometer 10 with a the gap 13 being as small as necessary but as large as possible to ensure an optimum homogeneous magnetic field between the pole shoes, e.g. smaller than 7 cm in width and in particular smaller than 5 cm. A bench-top spectrometer has a weight less than 200 kg and preferably less than 150 kg and can thus be transported and aligned much easier than a larger spectrometer.

At least if ferromagnetic pole shoes 12 are used, the size of the gap 13 is related to the size and also the weight of the spectrometer 10. Since the X-ray source for the combined EPR and X-ray measurements is usually stationary, in particular provided by a synchrotron facility, it is advantageous to be able to use a rather small spectrometer 10. The efforts for transporting and for aligning the spectrometer 10 can thus be reduced compared to lager spectrometers.

The probe unit 40 and the probe head 50 shown in Fig. 1 are designed to perform the combined EPR and X-ray measurements on a liquid sample or a sample comprising solid particles in a liquid medium.

The probe unit 40 comprises a reactor receptacle 41 positioned outside the resonator 20. The reactor receptacle 41 serves as a reservoir for the liquid probe medium and is used for feeding reactants to the medium.

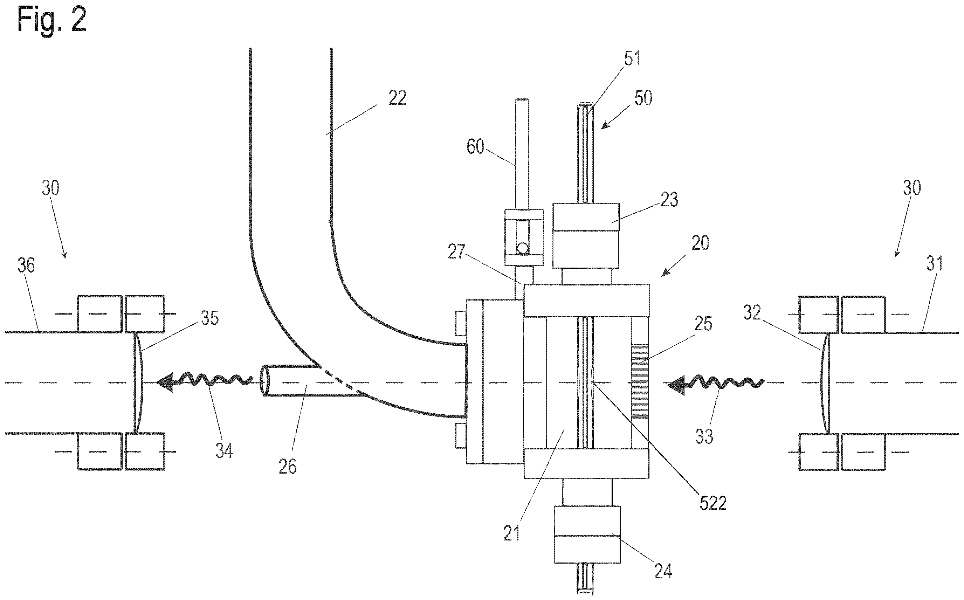

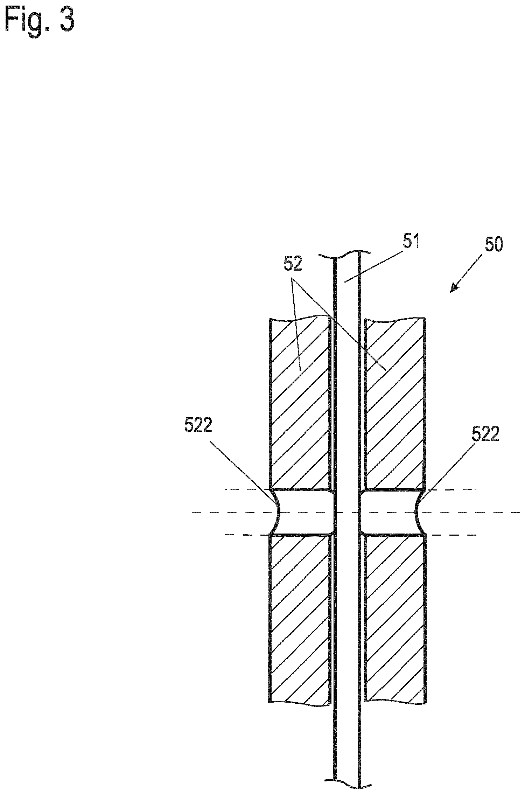

The probe head 50, which will be described in more detail in connection with Figs. 2 and 3, is either directly connected to a lower outlet of the reactor receptacle 41 (as shown in Fig. 1) or can also be connected to the reactor receptacle 41 via a hose or tube. After passing through the probe head 50, the medium is fed back into the reactor receptacle 41 via a re-circulation line 44 driven by a pump 45, in particular a micro-pump. The reactor receptacle 41 has several reactant inlets 42, one being used as a feedthrough for the re-circulation line 44. By way of example, a tube, for example a glass tube is shown as a reactant inlet 42 for dosing e.g. reactive gases like O₂ or liquid reactants and/or additives into the medium.

The reactor receptacle 41 shows further connectors that are used in this case as feedthroughs 43 for attenuated total reflectance infrared (ATR-IR) and/or ultraviolet (UV) probe heads. By using fiber optical spectroscopy heads, IR- and UV-spectroscopy can be performed in the medium in the reactor receptacle 41 by simply inserting the respective probe head 60 into the medium. The ATR-IR- and UV-probe heads 60 allow for additional in situ experiments with optical spectroscopy in different wavelength ranges. It is also possible to implement a further connector as a feedthrough for a fiber optical probe head for Raman spectroscopy, resulting in a simultaneous coupling of EPR/UV-vis/ATR-I R/Raman spectroscopy.

Fig. 2 is a side view of the resonator 20. The electromagnetic coils 11 and the pole shoes 12, between which the resonator 20 is positioned, are not depicted in Fig. 2 for conspicuousness.

The resonator 20 comprises an internal cavity 21 through which the probe head 50 and in particular the probe tube 51 pass, usually in a vertical direction. The resonator 20 is open on opposite sides in order to enable the X-ray passing the cavity 21.

The cavity 21 is connected to a tube which constitutes as a microwave guide 22. The microwave guide 22, which is shown only in part in Fig. 2, leads to a microwave generator for generating microwaves that are guided into the cavity 21. Absorption of microwave energy in the cavity 21 is measured while a magnetic field generated by the electromagnetic coils 11 (or by additional sweep coils) is varied. Absorption for example takes place by paramagnetic resonance of electrons within the sample passing through the probe tube 51. Tube feedthroughs 23, 24 are arranged above and below the cavity 21. They guide and fix the probe head 50 within the resonator 20.

The resonator 20 is furthermore designed to perform the XAS-measurements in parallel to the EPR measurements. Therefore, the resonator 20 has an entrance opening 25 for X-rays entering the cavity 21. The entrance opening 25 can consist of a metallic grid, which is transparent for X-rays, but hinders microwaves to escape out of the cavity 21. The entrance opening 25 can also be seen in Fig.1.

On the opposite side of the resonator 20 an exit opening 26 is formed, which allows X-rays to pass through the resonator 20. Entrance opening 25 and exit opening 26 are arranged for the X-rays to cross the path of the probe tube 51 perpendicular to the probe tube 51 and in the center of the cavity 21. While the entrance opening 25 is positioned on a front face of the resonator 20, the exit opening 26 is positioned on the same side of the resonator 20 as the microwave guide 22. For this reason, the exit opening 26 is provided as a guide (which in the present case is shaped as a tube) is connected to the microwave guide 22 in its lower, bended section around a hole which is drilled in the microwave guide 22. The tube acts like a waveguide for the X-rays but closes the exit opening 26 for the microwaves.

As mentioned above, the X-rays are usually provided by a large and stationary synchrotron facility. Fig. 2 shows the end-section of the source in form of a vacuum tube 31 for transmitting the x-rays from the beamline of the synchrotron to the resonator 20. The vacuum tube 31 ends in an exit window 32 through witch X-rays are emitted. The emitted X-rays form an incoming beam 33 for the resonator 20.

After having passed the cavity 21 and the medium in the probe tube 51, an outgoing beam 34 leaves the resonator 20 through the exit opening 26 and enters an entrance window 35 of a further vacuum tube 36 that leads to an X-ray detector (not shown here) for determining the energy and/or intensity of the outgoing beam 34.The two vacuum tubes 31 and 36 are aligned with each other and are usually provided as a part of the synchrotron facility. This way, for example the XAS-measurements can be performed on the medium passing the probe tube 51 and the probe head 50.

The orientation of the two vacuum tubes 31 and 36 is usually horizontal, which defines the geometry and orientation of the spectrometer 10, which is not depicted in Fig. 2. It is apparent that the spectrometer 10 has to be built around the resonator 20 in such a way that the X-ray path from the beamline to the detector is not obstructed by any component of the spectrometer 10, including a yoke that connects the two pole shoes 12 in order to form a closed magnetic loop and also by electronic units that drive and/or control the coils 11 and the microwave generator.

A section of the probe head 50 is shown in more detail in Fig. 3. It comprises the probe tube 51 through which the measured medium flows. Since the walls of the probe tube 51 have to be passed by the X-rays, the probe tube 51 is made from a material with a small X-ray absorption coefficient and has a small wall thickness of less than 0.5 millimeter (mm) and in particular less than 0.2 mm. A preferred material is polyimide, e.g. Kapton. Due to the thin walls, the probe tube 51 is rather fragile and is inserted into a support tube 52 to stabilize the probe tube 51 and prevent leakage of the probe medium for example into the cavity 21. The support tube 52 can e.g. be a quartz tube with a larger wall thickness in the range of millimeters, for example 1 to 2 mm.

In order to minimize X-ray absorption by the support tube 52, its wall thickness is reduced - possibly to zero - in a section where the X-rays pass the probe head 50. In the example shown in Fig. 3, the support tube has two holes 522 opposite to each other through which the X-rays pass.

By the combination of the inner probe tube 51 being made from a material with a small X-ray absorption and the support tube with the reduced wall thickness (or even hole) in the measurement section, a compromise between stability and performance for the XAS-measurements is established.

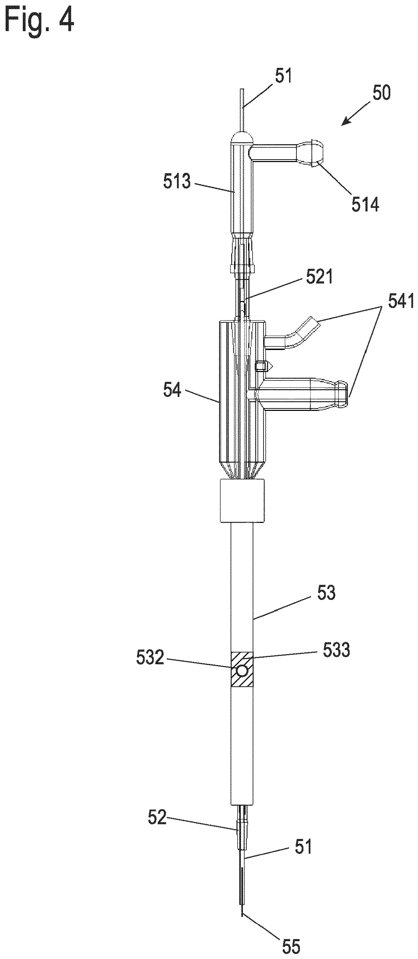

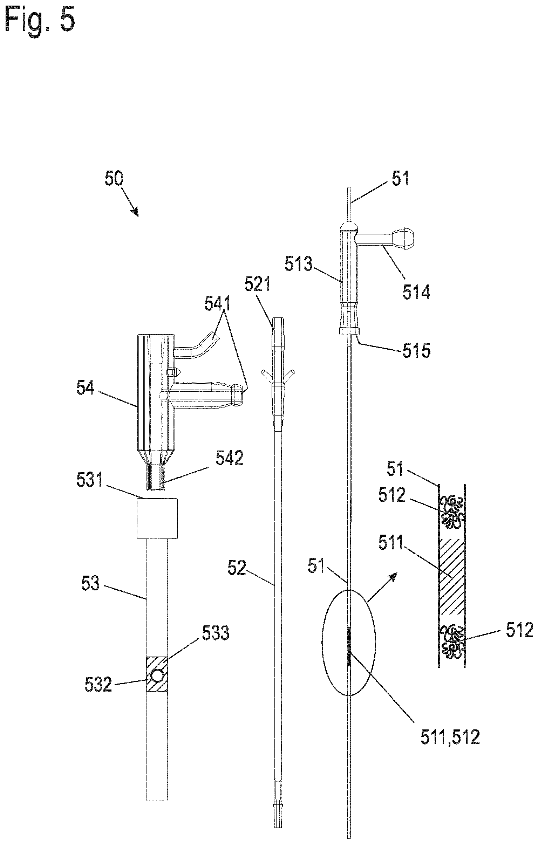

Fig. 4 and 5 show a second embodiment of a probe head 50 for use with a spectrometer 10 and the resonator 20 as shown in Fig. 1 and 2. Fig. 4 shows the probe head 50 in its assembled state, while Fig. 5 shows components of the probe head 50 separately. Furthermore, Fig. 5 shows an enlargement of the probe area of a probe tube 51 which is again part of the probe head 50.

While the probe head 50 shown in Fig. 3 is used for measurements in the liquid phase at room temperature, the probe head 50 shown in Fig. 4 and 5 is designed for measurements on a solid probe 511. Measurements can also be performed in situ during reactions, for example catalytic reactions occurring on surfaces of the solid probe 511. The probe head 50 can be connected to a source of reactants, which might be liquid or gaseous.

The probe head 50 of the second embodiment again comprises a concentric arrangement of tubes. The inner tube is the probe tube 51 into which the solid probe 511 is disposed. The solid probe 511 can for example be a solid material in form of a powder or a mesh. In order to study in situ reactions, the solid probe 511 has to be porous for a reacting gas or liquid being able to pass through. To fix the solid probe 511 in the measurement section of the probe tube 51, it is enclosed by two stopples of glass wool 512 that are pushed into the probe tube 51 and position the solid probe 511 between them. The probe tube 51 is for example made from Kapton or quartz glass with a wall thickness small enough for the X-rays to pass with sufficient intensity.

A gas adapter 513 is imposed on the upper part of the probe tube 51. The gas adapter 513 comprises a temper gas inlet 514 extending to the side. The gas adapter 513 further provides a socket 515 acting as a gas outlet through which the probe tube 51 passes centrally. The top of the gas adapter 513 through which the probe tube 51 is conducted is gas tightly closed. There is no internal connection between the temper gas inlet 514 and the probe tube 51. The gas adapter 513 allows to feed in a temper gas which then bathes the probe tube 51 on its outside.

The lower part of the probe tube 51 is then inserted into a support tube 52. The support tube has a cone 521 on its upper end that fits into the socket 514 of the gas adapter 513. Accordingly, a temper gas fed into the temper gas inlet 514 flows through the support tube 52 and then therefore bathes the probe tube 51 along its entire length, in particular within in the cavity 21 of the reactor 20. The temper gas can be used to control the temperature of the probe tube 51 and accordingly the solid probe 511. Additionally, reactant gases provided to the solid probe 511 are also preheated to or close to the temperature of the temper gas. Preferably nitrogen preheated to the desired temperature is used as a temper gas. The setup allows performing measurements of the solid probe 511 at elevated temperatures up to at least 500 K. In this respect, the support tube 52 can also be regarded as a temper tube.

To measure or control the temperature reached in the facility of the probe 511, a thermocouple 55 can be introduced from the lower opening of the probe head 50. It is preferred to position the thermocouple 55 close to the solid probe 511, but still leave it outside the cavity 21 in order to avoid absorption of microwaves by the metallic thermocouple 55 and, thus, disturbance of cavity tuning. It is also possible to perform an ex situ determination of the temperature by measuring the temperature at the location of the solid probe 511 for a given temperature and flux of the temper gas, which are also used during the EPR and X-ray measurements.

As described, the setup consisting of the probe tube 51 within the support tube 52 (temper tube) can be used for measurements performed at elevated temperatures of the solid probe 511. While the setup is well suited for temperatures that are only slightly higher than room temperature, an undesired warming-up of the resonator 20 could occur when performing measurements at higher temperatures, for example at temperatures higher than 50 K above room temperature. A warming-up of the resonator 20 during the measurements can change the resonance behavior of the cavity 21 and therefore disturb the measurements.

One option to prevent the resonator from being warmed-up is to flood the cavity 21 of the resonator with a permanent gas flow, e.g. a nitrogen gas flow. An alternative solution is realized in the embodiment shown in Figs. 4 and 5. The probe head 50 comprises a further tube concentric to the probe tube 51 and the support tube 52, namely an insulation tube 53. The insulation tube 53 encompasses the support tube 52 at least in the section inside the resonator 20.

The insulation tube 53 is preferably made from a thermally insulated material, for example Polytetrafluoroethylene (PTFE), also known as Teflon, or a double-walled evacuated quartz dewar. The insulating tube 53 has a connector 531 on its top side for connection with the further gas adapter 54.

The further gas adapter accordingly also comprises a gas inlet 541 extending to the side and a connector 542 on its lower side for connecting to the insulation tube 53. Gas, for example nitrogen gas, at room temperature fed through the gas inlet 541 flows through the connector 542 and the insulation tube 53. The gas thus acts as a cooling gas and keeps the insulation tube 53 at room temperature, thereby preventing a warming-up of the resonator 20.

The insulation tube 53 has holes 532 on each side for X-rays being able to pass the insulation tube 53 without any absorption. Thus, the holes 532 have a similar effect than the holes 522 in the support tube 52 of the first embodiment. In order to prevent the cooling gas from exiting the insulation tube 53 through the holes 532, the holes 532 are covered by a foil 533, for example a Kapton foil.

In both embodiments shown, the probe tube 51 is cylindrically formed and has an equal inner and outer diameter over its entire length. In an alternative embodiment, at least one section, preferably located around the probe, has an enlarged diameter compared to the remaining sections. The enlarged diameter in the X-ray measurement spot leads to an enhanced X-ray absorption, which can be desired to achieve a better signal-to-noise ratio for the X-ray measurements. However, the total amount of probe medium within the cavity is smaller than it would be if the entire probe tube had the enlarged diameter. This can be advantageous if the load of the probe medium within the cavity negatively effects the EPR signal, e. g. the medium is highly polar.

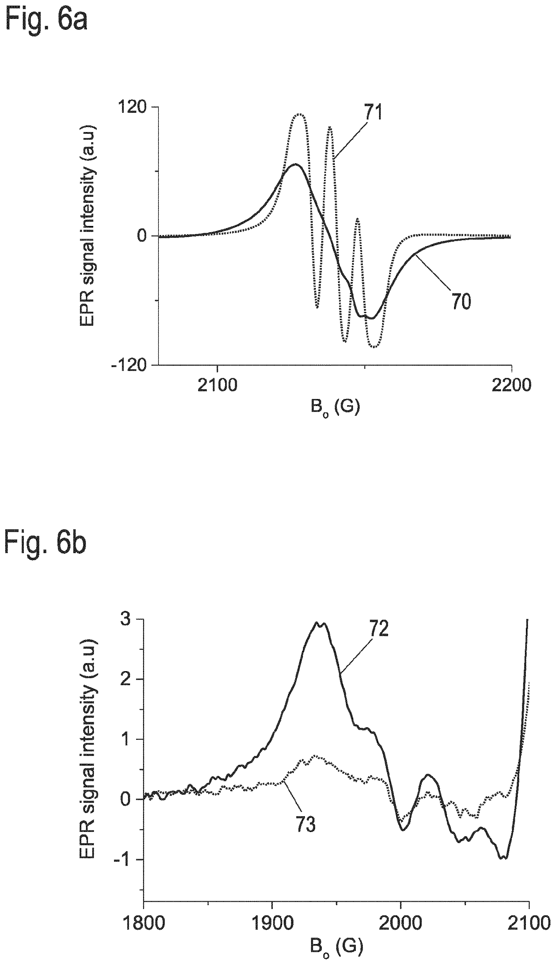

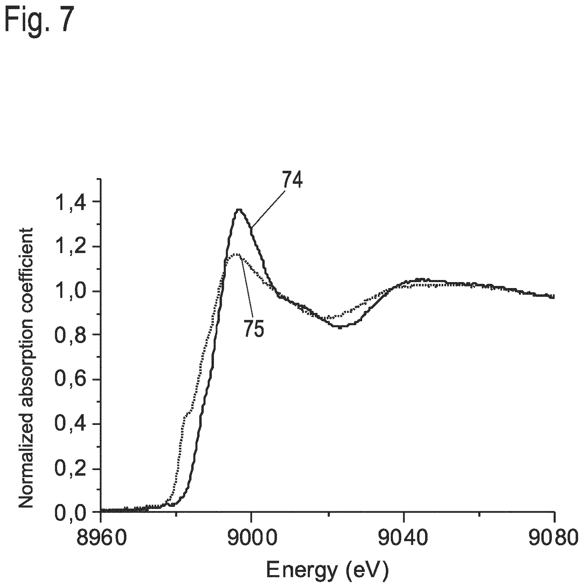

Figs. 6a, b and 7 show results of a combined EPR and XAS experiment performed with a probe 50 according to the first embodiment shown in Fig. 3 and the general setup as shown in Figs. 1 and 2.

The example concerns a selective aerobic oxidation of a primary alcohol to an aldehyde in liquid phase at room temperature by a catalytic system containing Cu^{I}OTf/2,2-bipyridine (bpy), N-methylimidazole (NMI) and 2,2,6,6-tetramethylpiperidine-1-oxyl (TEMPO) in acetonitrile.

The catalytic cycle involves a Cu^{I}/Cu^{II} redox shuttle with participation of TEMPO radicals. However, the structure of the active Cu species (particularly whether a Cu^{II} dimer is formed as a plausible reactive intermediate) could so far not be solved by EPR, UV-vis and IR spectroscopy alone.

Figs. 6a and 6b show results of EPR measurements on the measured system in form of two diagrams. In each case the horizontal axis relates to a magnetic field B₀ applied to the sample measured in Gauss (G). The two diagrams differ in the range of the magnetic field. The vertical axis relates to an EPR signal intensity in arbitrary units (a.u.).

Each diagram shows two measured curves 70, 71 and 72, 73, respectively. In each case, one of the curves (curve 70 and curve 72) is measured at the beginning of the reaction, i.e. at the time of dosing a certain amount of benzyl alcohol (BzOH) used as a reactant. The other one of the curves (curve 71 and curve 73) is measured after a reaction time of 370 s (seconds) post dosing. Further measurements of intermediate reaction times were also performed and show the evolution of the curves. The intermediate results are not shown for clarity here.

The magnetic field used for the measurement of curves 70 and 71 in Fig. 6a makes this measurement sensitive to the TEMPO species, while the magnetic field used for the measurement of curves 72 and 73 in Fig. 6b makes this measurement sensitive to Cu^{II} atoms.

Fig. 7 shows results of an XAS-measurement performed in parallel with the same probe. The horizontal axis relates to an analyzed energy of the transmitted X-rays, measured in electron volts (eV). The vertical axis relates to a normalized absorption coefficient. Again, two curves 74, 75 are shown, wherein curve 74 is measures at the time of dosing and curve 75 after a reaction time of 370 s.

While EPR monitors paramagnetic species such as Cu^{II} single sites and TEMPO radicals (but not diamagnetic Cu^{I} species and strongly magnetically coupled Cu^{II} dimers (Fig. 6a, b), XAS can monitor both paramagnetic and diamagnetic Cu species (i.e. Cu^{I} and Cu^{II} species including dimers) but not TEMPO radicals (Fig. 7).

Additional information can be obtained by simultaneously performed UV-vis spectroscopy that can reflect both Cu^{I}/Cu^{II} species. Furthermore, ATR-FTIR spectroscopy can be performed to detect catalytic activity by visualizing the alcohol-to-aldehyde conversion.

In summary, the integrated evaluation of results from EPR and XAS measurements, possibly assisted by optical spectroscopy, gives a reliable correlation between structure and valence state of Cu and TEMPO sites and the catalytic performance which enables to improve the mechanistic understanding of this catalytic process. This combined technique has general application potential in different fields of biology and/or chemistry, in which changes of paramagnetic and diamagnetic species are involved.

### Reference signs

- 10: spectrometer
- 11: electromagnetic coil
- 12: pole shoe
- 13: gap

- 20: resonator
- 21: cavity
- 22: microwave guide
- 23, 24: tube feedthrough
- 25: entrance opening
- 26: exit opening
- 27: IR/UV-head feedthrough

- 30: X-ray setup
- 31: vacuum tube (from the beamline source)
- 32: exit window
- 33: incoming beam
- 34: outgoing beam
- 35: entrance window
- 36: further vacuum tube (to the detector)

- 40: probe unit
- 41: reactor receptacle
- 42: reactant inlet
- 43: ATR-FTIR/UV-head feedthrough
- 44: re-circulation line
- 45: micro-pump

- 50: probe head

- 51: probe tube
- 511: solid probe
- 512: glass wool
- 513: gas adapter
- 514: temper gas inlet
- 515: socket (gas outlet)
- 52: support tube (temper tube)
- 521: cone
- 522: hole

- 53: insulation tube
- 531: connector
- 532: hole
- 533: foil

- 54: further gas adapter
- 541: gas inlet
- 542: connector (gas outlet)

- 60: ATR-FTIR/UV-spectrometer head

- 70-73: measured curve

## Claims

1. Probe setup for combined electron parametric resonance and X-ray absorption measurements, comprising a microwave resonator (20) and a probe head (50) arranged in a cavity (21) of the resonator (20), the resonator (20) having an entrance opening (25) and an exit opening (26) for an X-ray beam, **characterized in that** the probe head (50) comprises a probe tube (51) which runs through the cavity (21) and allows to transport liquid or gaseous media through the cavity and is positioned to cross the X-ray beam.

2. The probe setup according to claim 1, wherein the probe tube (51) is made from quartz glass.

3. The probe setup according to claim 1 or 2, wherein a section of the probe tube (51) that is positioned in the cavity (21) has a reduced wall thickness in the section of the probe tube (51) that is exposed to the X-rays to decrease X-ray absorption by the probe tube (51).

4. The probe setup according to claim 1, wherein the probe tube (51) is made from Polyimide with a wall thickness less than 0.5 mm and preferably less than 0.2 mm.

5. Probe setup according to one of claims 1 to 4, wherein the probe tube (51) is inserted into at least one further tube and wherein a section of the further tube that is positioned in the cavity (21) has a reduced wall thickness in the section of the further tube that is exposed to the X-rays to decrease X-ray absorption by the further tube.

6. The probe setup according to claim 5, wherein the further tube is a support tube (52) that closely encompasses the probe tube (51).

7. The probe setup according to claim 6, wherein the support tube (52) is made from quartz glass.

8. The probe setup according to claim 6 or 7, wherein the support tube (52) has a wall thickness in the range of 1 to 2 mm.

9. The probe setup according to one of claims 6 to 8, wherein a gas adapter (531) is connected to the support tube (52) for feeding a temper gas to the support tube (52) and for tempering at least a section of the probe tube (51).

10. The probe setup according to one of claims 5 to 9, wherein the further tube is an insulation tube (53) that encompasses the probe tube (51) and/or the support tube (52).

11. The probe setup according to claim 10, wherein the insulation tube (53) is made from a plastic material, in particular from PTFE, or comprises a double-walled evacuated quartz dewar.

12. The probe setup according to claim 10 or 11, wherein a further gas adapter (54) is connected to the insulation tube (53) for feeding a cooling gas to the insulation tube (53).

13. The probe setup according to one of claims 5 to 12, wherein the wall thickness of the further tube is reduced to zero by placing at least one hole (522, 532) in the material of the further tube.

14. The probe setup according to claim 13 and one of claims 6 to 9, wherein at least one hole (522) is formed in the wall of the support tube (52).

15. The probe setup according to claim 13 and one of claims 10 to 12, wherein at least one hole (532) is formed in the wall of the insulation tube (53).

16. The probe setup according to claim 15, wherein the at least one hole (532) is covered by Kapton foil (533).

17. The probe setup according to one of claims 1 to 16, comprising a reactor receptacle (41), wherein the probe tube (51) is connected to the reactor receptacle (41) for feeding a liquid probe medium through the probe tube (51).

18. The probe setup according to one of claims 1 to 16, comprising a gas supply, wherein the probe tube (51) is connected to the gas supply for feeding a gaseous medium through the probe tube (51).

19. The probe setup according to one of claims 1 to 18, wherein the probe tube (51) has an enlarged diameter within at least one section disposed in the cavity (21).

20. EPR spectrometer with at least one coil (11) for providing a magnetic field within a gap (13) and a probe setup as claimed in one or more of claims 1 to 19, wherein the resonator (20) of the probe setup is positioned in the gap (13).

21. The EPR spectrometer according to claim 20, which is designed as a bench-top spectrometer.

22. The EPR spectrometer according to claim 21, having a weight below 200 kg and in particular below 150 kg.

23. The EPR spectrometer according to one of claims 20 to 22, wherein a width of the gap (13) is smaller than 7 cm and preferably smaller than 5 cm.

## Patentansprüche

1. Probenaufbau für kombinierte Messungen von elektronenparametrischer Resonanz und Röntgenabsorption, umfassend einen Mikrowellenresonator (20) und einen Probenkopf (50), der in einem Hohlraum (21) des Resonators (20) angeordnet ist, wobei der Resonator (20) eine Eintrittsöffnung (25) und eine Austrittsöffnung (26) für einen Röntgenstrahl aufweist, **dadurch gekennzeichnet, dass** der Probenkopf (50) ein Probenrohr (51) umfasst, das durch den Hohlraum (21) verläuft, den Transport von flüssigen oder gasförmigen Medien durch den Hohlraum ermöglicht und quer im Röntgenstrahl positioniert ist.

2. Probenaufbau nach Anspruch 1, wobei das Probenrohr (51) aus Quarzglas besteht.

3. Probenaufbau nach Anspruch 1 oder 2, wobei ein Abschnitt des Probenrohrs (51), das in dem Hohlraum (21) positioniert ist, eine reduzierte Wanddicke in dem Abschnitt des Probenrohrs (51) aufweist, der den Röntgenstrahlen ausgesetzt ist, um die Röntgenabsorption durch das Probenrohr (51) zu verringern.

4. Probenaufbau nach Anspruch 1, wobei das Probenrohr (51) aus Polyimid mit einer Wanddicke von weniger als 0,5 mm und vorzugsweise weniger als 0,2 mm besteht.

5. Probenaufbau nach einem der Ansprüche 1 bis 4, wobei das Probenrohr (51) in mindestens ein weiteres Rohr eingeführt ist und wobei ein Abschnitt des weiteren Rohrs, das in dem Hohlraum (21) positioniert ist, eine reduzierte Wanddicke in dem Abschnitt des weiteren Rohrs aufweist, der den Röntgenstrahlen ausgesetzt ist, um die Röntgenabsorption durch das weitere Rohr zu verringern.

6. Probenaufbau nach Anspruch 5, wobei das weitere Rohr ein Trägerrohr (52) ist, das das Probenrohr (51) eng umschließt.

7. Probenaufbau nach Anspruch 6, wobei das Trägerrohr (52) aus Quarzglas besteht.

8. Probenaufbau nach Anspruch 6 oder 7, wobei das Trägerrohr (52) eine Wanddicke im Bereich von 1 bis 2 mm aufweist.

9. Probenaufbau nach einem der Ansprüche 6 bis 8, wobei ein Gasadapter (531) mit dem Trägerrohr (52) verbunden ist, um dem Trägerrohr (52) ein Temperierungsgas zuzuführen und mindestens einen Abschnitt des Probenrohrs (51) zu temperieren.

10. Probenaufbau nach einem der Ansprüche 5 bis 9, wobei das weitere Rohr ein Isolationsrohr (53) ist, das das Probenrohr (51) und/oder das Trägerrohr (52) umschließt.

11. Probenaufbau nach Anspruch 10, wobei das Isolationsrohr (53) aus einem Kunststoffmaterial, insbesondere aus PTFE, besteht oder ein doppelwandiges evakuiertes Quarz-Dewargefäß umfasst.

12. Probenaufbau nach Anspruch 10 oder 11, wobei ein weiterer Gasadapter (54) mit dem Isolationsrohr (53) verbunden ist, um dem Isolationsrohr (53) ein Kühlgas zuzuführen.

13. Probenaufbau nach einem der Ansprüche 5 bis 12, wobei die Wanddicke des weiteren Rohrs auf null reduziert ist, indem mindestens ein Loch (522, 532) in das Material des weiteren Rohrs eingebracht ist.

14. Probenaufbau nach Anspruch 13 und einem der Ansprüche 6 bis 9, wobei mindestens ein Loch (522) in der Wand des Trägerrohrs (52) gebildet ist.

15. Probenaufbau nach Anspruch 13 und einem der Ansprüche 10 bis 12, wobei mindestens ein Loch (532) in der Wand des Isolationsrohrs (53) gebildet ist.

16. Probenaufbau nach Anspruch 15, wobei das mindestens eine Loch (532) durch Kaptonfolie (533) abgedeckt ist.

17. Probenaufbau nach einem der Ansprüche 1 bis 16, umfassend ein Reaktorgefäß (41), wobei das Probenrohr (51) mit dem Reaktorgefäß (41) verbunden ist, um ein flüssiges Probenmedium durch das Probenrohr (51) zuzuführen.

18. Probenaufbau nach einem der Ansprüche 1 bis 16, umfassend eine Gasversorgung, wobei das Probenrohr (51) mit der Gasversorgung verbunden ist, um ein gasförmiges Medium durch das Probenrohr (51) zu führen.

19. Probenaufbau nach einem der Ansprüche 1 bis 18, wobei das Probenrohr (51) einen vergrößerten Durchmesser innerhalb mindestens eines Abschnitts, der in dem Hohlraum (21) angeordnet ist, aufweist.

20. EPR-Spektrometer mit mindestens einer Spule (11) zum Bereitstellen eines Magnetfeldes innerhalb eines Spalts (13) und Probenaufbau nach einem oder mehreren der Ansprüche 1 bis 19, wobei der Resonator (20) des Probenaufbaus in dem Spalt (13) positioniert ist.

21. EPR-Spektrometer nach Anspruch 20, das als Tischspektrometer gestaltet ist.

22. EPR-Spektrometer nach Anspruch 21, aufweisend ein Gewicht unter 200 kg und insbesondere unter 150 kg.

23. EPR-Spektrometer nach einem der Ansprüche 20 bis 22, wobei eine Breite des Spalts (13) kleiner als 7 cm und vorzugsweise kleiner als 5 cm ist.

## Revendications

1. Installation d'échantillon pour des mesures combinées de résonance paramétrique électronique et d'absorption des rayons X, comprenant un résonateur hyperfréquence (20) et une tête d'échantillon (50) agencée dans une cavité (21) du résonateur (20), le résonateur (20) ayant une ouverture d'entrée (25) et une ouverture de sortie (26) pour un faisceau de rayons X, **caractérisée en ce que** la tête d'échantillon (50) comprend un tube d'échantillon (51) qui traverse la cavité (21) et permet de transporter des milieux liquides ou gazeux à travers la cavité et est positionné pour croiser le faisceau de rayons X.

2. Installation d'échantillon selon la revendication 1, dans laquelle le tube d'échantillon (51) est réalisé à partir de verre de quartz.

3. Installation d'échantillon selon la revendication 1 ou 2, dans laquelle une section du tube d'échantillon (51) qui est positionnée dans la cavité (21) a une épaisseur de paroi réduite dans la section du tube d'échantillon (51) qui est exposée aux rayons X afin de diminuer une absorption des rayons X par le tube d'échantillon (51).

4. Installation d'échantillon selon la revendication 1, dans laquelle le tube d'échantillon (51) est réalisé à partir de polyimide avec une épaisseur de paroi inférieure à 0,5 mm et de préférence inférieure à 0,2 mm.

5. Installation d'échantillon selon l'une des revendications 1 à 4, dans laquelle le tube d'échantillon (51) est inséré dans au moins un tube supplémentaire et dans laquelle une section du tube supplémentaire qui est positionnée dans la cavité (21) a une épaisseur de paroi réduite dans la section du tube supplémentaire qui est exposée aux rayons X afin de diminuer une absorption des rayons X par le tube supplémentaire.

6. Installation d'échantillon selon la revendication 5, dans laquelle le tube supplémentaire est un tube de support (52) qui englobe étroitement le tube d'échantillon (51).

7. Installation d'échantillon selon la revendication 6, dans laquelle le tube de support (52) est réalisé à partir de verre de quartz.

8. Installation d'échantillon selon la revendication 6 ou 7, dans laquelle le tube de support (52) a une épaisseur de paroi dans la plage de 1 à 2 mm.

9. Installation d'échantillon selon l'une des revendications 6 à 8, dans laquelle un adaptateur de gaz (531) est raccordé au tube de support (52) pour apporter un gaz de trempe au tube de support (52) et pour tremper au moins une section du tube d'échantillon (51).

10. Installation d'échantillon selon l'une des revendications 5 à 9, dans laquelle le tube supplémentaire est un tube d'isolation (53) qui englobe le tube d'échantillon (51) et/ou le tube de support (52).

11. Installation d'échantillon selon la revendication 10, dans laquelle le tube d'isolation (53) est réalisé à partir d'un matériau plastique, en particulier à partir de PTFE, ou comprend un vase Dewar en quartz sous vide à double paroi.

12. Installation d'échantillon selon la revendication 10 ou 11, dans laquelle un adaptateur de gaz supplémentaire (54) est raccordé au tube d'isolation (53) pour apporter un gaz de refroidissement au tube d'isolation (53).

13. Installation d'échantillon selon l'une des revendications 5 à 12, dans laquelle l'épaisseur de paroi du tube supplémentaire est réduite à zéro en plaçant au moins un trou (522, 532) dans le matériau du tube supplémentaire.

14. Installation d'échantillon selon la revendication 13 et l'une des revendications 6 à 9, dans laquelle au moins un trou (522) est formé dans la paroi du tube de support (52).

15. Installation d'échantillon selon la revendication 13 et l'une des revendications 10 à 12, dans laquelle au moins un trou (532) est formé dans la paroi du tube d'isolation (53).

16. Installation d'échantillon selon la revendication 15, dans laquelle l'au moins un trou (532) est couvert d'une feuille de Kapton (533).

17. Installation d'échantillon selon l'une des revendications 1 à 16, comprenant un réceptacle de réacteur (41), dans laquelle le tube d'échantillon (51) est raccordé au réceptacle de réacteur (41) pour apporter un milieu d'échantillon liquide à travers le tube d'échantillon (51).

18. Installation d'échantillon selon l'une des revendications 1 à 16, comprenant une alimentation en gaz, dans laquelle le tube d'échantillon (51) est raccordé à l'alimentation en gaz pour apporter un milieu gazeux à travers le tube d'échantillon (51).

19. Installation d'échantillon selon l'une des revendications 1 à 18, dans laquelle le tube d'échantillon (51) a un diamètre agrandi au sein d'au moins une section disposée dans la cavité (21).

20. Spectromètre RPE avec au moins une bobine (11) pour fournir un champ magnétique au sein d'un écartement (13) et une installation d'échantillon telle que revendiquée dans une ou plusieurs des revendications 1 et 19, dans lequel le résonateur (20) d'installation d'échantillon est positionné dans l'écartement (13).

21. Spectromètre RPE selon la revendication 20, qui est conçu sous la forme d'un spectromètre de table.

22. Spectromètre RPE selon la revendication 21, ayant un poids en dessous de 200 kg et en particulier en dessous de 150 kg.

23. Spectromètre RPE selon l'une des revendications 20 à 22, dans lequel une largeur d'écartement (13) est plus petite que 7 cm et de préférence plus petite que 5 cm.
